# EUROPEAN PATENT SPECIFICATION

(11) **EP 0 509 418 B1**
(45) Date of publication and mention of the grant of the patent: **06.11.1996**
(21) Application number: 92106266.7
(22) Date of filing: 10.04.1992
(51) Int. Cl.: G11B 7/00, G11C 11/22

(54) **Optical memory**
Optischer Speicher
Mémoire optique

(30) Priority: 12.04.1991 JP 108783/91
(43) Date of publication of application: 21.10.1992
(73) Proprietor: YOZAN INC., Tokyo 155 (JP); SHARP KABUSHIKI KAISHA, Osaka 545 (JP)
(72) Inventor: Takatori, Sunao, Tokyo 155 (JP)
(74) Representative: Grünecker, Kinkeldey, Stockmair & Schwanhäusser Anwaltssozietät

(56) References cited:
- EP-A- 0 235 748
- EP-A- 0 352 814
- EP-A- 0 402 944
- GB-A- 2 205 173

## Description

### FIELD OF THE INVENTION

The present invention relates to an optical memory, according to the preamble part of claim 1 and the preamble part of claim 2.

### BACKGROUND OF THE INVENTION

An optical memory according the preamble part of claim 1 and claim 2 is known from EP-A-0 402 944. This document describes a liquid crystal device having two optically different states switchable in response to incident light. A ferroelectric liquid crystal layer (10) is sandwiched by a pair of front and rear alignment layers (7a,7b) to establish the two stable states in the ferroelectric liquid crystal layer. An front electrode layer is disposed on the front alignment layer. A dielctric mirror (6) is disposed on the rear alignment layer (7a). A photoconductive layer (4) is disposed on the dielectric mirror and responsive to the incident light incident from the rear face of the liquid crystal device to increase its electroconductivity. A barrier metal layer (13) is disposed on the photoconductive layer and forms a Schottky diode in combination with the photoconductive layer. A rear electrode is disposed on the barrier metal layer and is divided into a plurality of sub-electrodes to apply various bias voltage on the ferroelectric liquid crystal layer.

Conventionally, an optical disk is known as a device for recording information of optical signal. A magneto-optical disk is thought to be the most convincing by way of an optical disk which can be read and written. The standardization of it has been prepared. (Nikkei Electronics, 91-2-4, p75)

But the reading and writing information of an optical disk is sequential because the information is put in sequence on a magnetic head. It takes twenty or thirty millisecond for access, which is approximately thousand times of necessary time for memory IC. It means that the access speed of an optical disk is extremely slow and it is originally inappropriate to random access of two-dimensional information.

It is the object of the present invention to provide an optical memory having a high reading and writing speed.

This object is solved by the subject matter of claims 1 and 2.

Preferred embodiments of the present invention will be described in the following in connection with the accompanying drawings.

### BRIEF DESCRIPTION OF THE DRAWINGS

Fig. 1 shows a cross section of an optical memory using thin film with photovoltaic effect.

Fig. 2 shows a circuit to indicate the state of electric connection between a liquid crystal panel and a thin film with photovoltaic effect.

Fig. 3 shows a cross section of an optical memory using thin film with photoconductive effect.

Fig. 4 shows a circuit to indicate the state of electric connection between a liquid crystal panel and a thin film with photoconductive effect.
"1" shows a thin film (light receiving means with photovoltaic effect).
"2" shows a ferroelectric liquid crystal panel.
"3" shows a part.
"4" shows an amplifier.
"5" shows an electrode.
"6" shows a glass board.
"7" shows a thin film (light receiving means with photoconductive effect).
"SW1" and "SW2" show switches.

### PREFERRED EMBODIMENT OF THE PRESENT INVENTION

Hereinafter, the first embodiment of the optical memory according to the present invention is described with reference to the attached drawings.

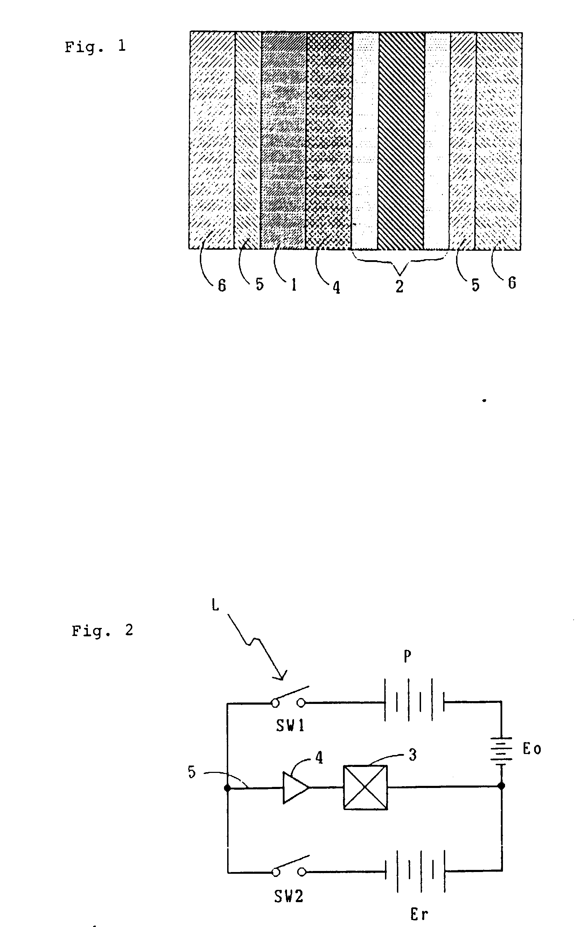

In Fig. 1, the optical memory comprises, for example, thin film 1 of a-SiH, amplifier 4 and ferroelectric liquid crystal panel 2.

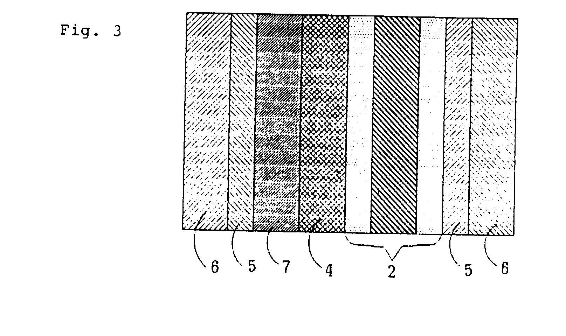

Fig. 2 shows the electric connection of liquid crystal panel 2, amplifier 4 and thin film 1. Electrode "5" of a part "3" of a liquid crystal panel 2 (a unit used for displaying one pixel on a liquid crystal panel) is connected to "P" which is the corresponding part of thin film "1". "P" has a dimension corresponding to a size of one plxel to be processed. Thin film "1" generates electromotive force by light incidence "L". Thin film 1 comprises solar battery, in whose minute area the power for part "3" generated. The voltage generated in the area is amplified in amplifier 4. The enough voltage to drive a liquid crystal panel is secured and solar battery with rather lower voltage generated can be used. High voltage is necessary to change the state of liquid crystal panel when dipole moment is large. The amplifier makes it possible to drive a liquid crystal panel with rather large dipole moment. In Fig. 2, the generation of electromotive force by light is shown by switch "SW1".

Lucent electrodes "5" are adhered on the both out sides to thin film "1", amplifier 4 and liquid crystal panel "2" which are adhered one another on the both out sides. When the state changes by the incidence of light, bias voltage "E0" is added to lucent electrodes "5". The bias voltage is controlled according to the input conditions of light.

The whole of the optical memory is protected by covering by glass boards "6" on both sides of it.

In order to write on optical memory, two-dimensional optical information such as an image is inputted to thin film "1". Consequently, the power generated in part "P" which has received optical energy is amplified in amplifier 4. It causes electromotive force enough to generate the change of state of liquid crystal in connection with bias voltage "E0", and the state of liquid crystal of part "3" corresponding to it is changed.

It is possible to read optically the state of part "3" as the two-dimensional image from the opposite side of thin film 1. An image scanner can be used for the tool for reading.

In this way, optical memory makes it possible to write and read directly the two-dimensional optical information. The necessary time for writing is only the time of changing state of liquid crystal. The necessary time for changing state can be expected to be from 100 to 999 micro second on mass production.

It is necessary to clear the storage of optical memory in order to write new information after writing some information on an optical memory. Power source "Er" for reverse-bias and switch "SW2" are connected to lucent electrode "5" to do so. The liquid crystal of all parts are restored to the initial state in a lump by closing switch "SW2".

Next, the second embodiment is described according to Fig. 3.

Fig. 3 shows a section of the second embodiment. Thin film "7" which has photoconductive effect is used instead of the thin film which has photovoltaic effect.

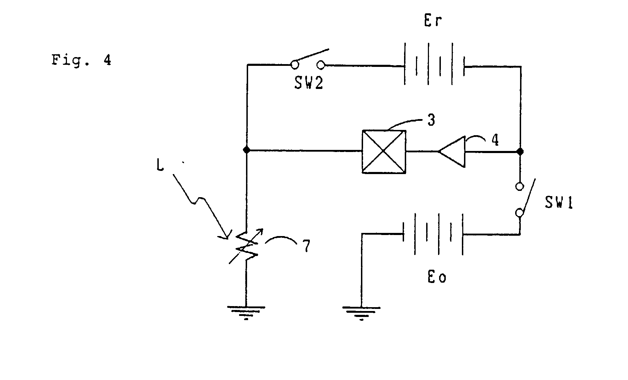

In Fig. 4, thin film "7" is shown as a variable resistance of an equivalent circuit. The state of the liquid crystal of part "3" changes because of the increase of electromotive force for part "3" by bias voltage "E0" of lucent electrode "5" when the resistance of thin film "7" decreases which is caused by the photoconductive effect, and because of the power amplified enough by amplifier 4. Reverse electromotive force of power source "Er" is used for clarifying memory in this embodiment, too.

As mentioned above, the present invention makes it possible to access in high speed, read and write appropriately to random access of the two-dimensional information in high speed.

## Claims

1. An optical memory comprising a light receiving panel (1) made from material with photovoltaic effect, said light receiving panel (1) being divided into a plurality of minute areas (P) corresponding to image pixels to be processed, said light receiving panel developing in response to incident light an electromotive force due to said photovoltaic effect, a ferroelectric liquid crystal panel (2) being divided into a corresponding plurality of liquid crystal parts (3) whose electrodes are electrically connected in parallel to said electromotive force generated by said minute areas of said light receiving panel (1)
characterized in that
said optical memory further comprises a voltage amplifier panel (4) being located physically and electrically between said light receiving panel (1) and said liquid crystal panel (2), a transparent electrode panel (5) connected to the liquid crystal panel (2) and a switch (SW2) for switchably connecting said electrode panel to a power supply for impressing an electric field (Er) having a reverse directon in regard to the electric field generated by said light receiving panel across said amplifier panel and said liquid crystal panel.

2. An optical memory comprising a light receiving panel (7) made from material with photoconductive effect, said light receiving panel (7) being divided into a plurality of minute areas (P) corresponding to image pixels to be processed, said light receiving panel changing resistance dependent from the amount of incident light, and a ferroelectric liquid crystal panel (2) being divided into a corresponding plurality of liquid crystal parts (3), which are electrically connected to said minute area of said light receiving panel (1)
characterized in that
said optical memory further comprises a voltage amplifier panel (4) being located between the light receiving panel (7) and said liquid crystal (2) and forming said electrical connection and further comprises a transparent electrode panel (5) connected to the liquid crystal panel, a first switch (SW1) for switchably connecting said electrode panel to a first power supply for supplying a first voltage (Eo) causing a current through said liquid crystal panel, said amplifier panel and said resistor means formed by said light receiving panel and a second switch (SW2) for switchably connecting said electrode panel to a second power supply for supplying a second voltage (Er) to said amplifier panel and said liquid crystal panel having an opposite polarity to the first voltage.

## Patentansprüche

1. Ein optischer Speicher umfassend ein lichtempfangendes Feld (1), das aus Material besteht, das einen photovoltaischen Effekt zeigt, wobei das lichtempfangende Feld (1) in eine Mehrzahl kleiner Bereiche (P) geteilt ist, die zu verarbeitenden Bildpixeln entsprechen, wobei das lichtempfangende Feld als Antwort auf einfallendes Licht aufgrund des photovoltaischen Effekts eine elektromotorische Kraft entwickelt, ein ferroelektrisches Flüssigkristallfeld (2), das in eine entsprechende Mehrzahl von Flüssigkristallteilen (3) geteilt ist, deren Elektroden parallel mit der elektromotorischen Kraft, die durch die kleinen Bereiche des lichtempfangenden Felds (1) erzeugt werden, elektrisch verbunden sind,
**dadurch gekennzeichnet,** daß
der optische Speicher weiterhin aufweist ein Spannungsverstärkerfeld (4), das physikalisch und elektrisch zwischen dem lichtempfangenden Feld (1) und dem Flüssigkristallfeld (2) lokalisiert ist, ein transparentes Elektrodenfeld (5), das mit dem Flüssigkristallfeld (2) und einem Schalter (SW2) zum schaltbaren Verbinden des Elektrodenfelds mit einer Energieversorgung zum Einprägen eines elektrischen Felds (Er) verbunden ist, welches in bezug auf das elektrische Feld, das durch das lichtempfangende Feld über dem Verstärkerfeld und dem Flüssigkristallfeld erzeugt wird, umgekehrte Richtung hat.

2. Ein optischer Speicher umfassend ein lichtempfangendes Feld (7), das aus Material besteht, das einen fotoleitenden Effekt zeigt, wobei das lichtempfangende Feld (7) in eine Mehrzahl kleiner Bereiche (P) geteilt ist, die zu verarbeitenden Bildpixeln entsprechen, wobei das lichtempfangende Feld seinen Widerstand in Abhängigkeit von der Menge des einfallenden Lichts ändert, und ein ferroelektrisches Flüssigkristallfeld (2), das in eine entsprechende Mehrzahl von Flüssigkristallteilen (3) geteilt ist, die elektrisch mit dem kleinen Bereich des lichtempfangenden Felds (1) verbunden sind,
**dadurch gekennzeichnet,** daß
der optische Speicher weiter umfaßt ein Spannungsverstärkerfeld (4), das zwischen dem lichtempfangenden Feld (7) und dem Flüssigkristall (2) lokalisiert ist und die elektrische Verbindung bildet, und weiter aufweist ein transparentes Elektrodenfeld (5), das mit dem Flüssigkristallfeld verbunden ist, einen ersten Schalter (SW1) zum schaltbaren Verbinden des Elektrodenfelds mit einer ersten Energieversorgung zur Lieferung einer ersten Spannung (EO), die zu einem Strom durch das Flüssigkristallfeld führt, wobei das Verstärkerfeld und die Widerstandseinrichtung durch das lichtempfangende Feld gebildet sind, und einen zweiten Schalter (SW2) zum schaltbaren Verbinden des Elektrodenfelds mit einer zweiten Energieversorgung, um eine zweite Spannung (Er) mit zur ersten Spannung entgegengesetzter Polarität dem Verstärkerfeld und dem Flüssigkristallfeld zuzuführen.

## Revendications

1. Mémoire optique comprenant une couche réceptrice de lumière (1) constituée d'un matériau présentant un effet photovoltaïque , ladite couche réceptrice de lumière (1) étant divisée en une pluralité de très petites zones (P) correspondant a des pixels d'image à traiter ladite couche réceptrice de lumière développant, en réponse à une lumière incidente, une force électromotrice due audit effet photovoltaïque , un écran à cristaux liquides ferroélectriques (2) divisé en une pluralité correspondante de parties de cristaux liquides (3) dont les électrodes sont connectées électriquement en parallèle à ladite force électromotrice générée par lesdites très petites zones de ladite couche réceptrice de lumière (1)
caractérisée en ce que
ladite mémoire optique comprend, de plus, une couche amplificatrice de tension (4) placée physiquement et électriquement entre ladite couche réceptrice de lumière (1) et ledit écran à cristaux liquides (2) , une couche d'électrode transparente (5) connectée à l'écran à cristaux liquides (2) et un commutateur (SW2) pour connecter de façon commutable ladite couche d'électrode à une source d'énergie pour appliquer un champ électrique (Er) présentant une direction inverse par rapport au champ électrique généré par ladite couche réceptrice de lumière à travers ladite couche amplificatrice et ledit écran à cristaux liquides.

2. Mémoire optique comprenant une couche réceptrice de lumière (7) constituée d'un matériau présentant un effet photoconducteur, ladite couche réceptrice de lumière (7) étant divisée en une pluralité de très petites zones (P) correspondant a des pixels d'image à traiter, ladite couche réceptrice de lumière changeant de résistance en fonction de la quantité de lumière incidente, et un écran à cristaux liquides ferroélectriques (2) divisé en une pluralité correspondante de parties de cristaux liquides (3) qui sont connectées électriquement auxdites très petites zones de ladite couche réceptrice de lumière (1)
caractérisée en ce que
ladite mémoire optique comprend , de plus, une couche amplificatrice de tension (4) placée entre l'écran récepteur de lumière (7) et ledit cristal liquide (2) et formant ladite connexion électrique et comprend, de plus, une couche d'électrode transparente (5) connectée à l'écran à cristaux liquides, un premier commutateur (SW1) pour connecter de façon commutable ladite couche d'électrode à une première source de courant pour fournir une première tension (Eo) entraînant un courant à travers ledit écran à cristaux liquides , ladite couche amplificatrice et lesdits moyens de résistance formés par ladite couche réceptrice de lumière et un second commutateur (SW2) pour connecter par commutation ledit écran d'électrode à une seconde source d'énergie pour fournir une seconde tension (Er) à ladite couche amplificatrice et audit écran à cristaux liquides, présentant une polarité opposée à la première tension.
